Europäisches Patentamt

European Patent Office

Office européen des brevets

(11) Publication number: **0 215 429 B1**

(12) **EUROPEAN PATENT SPECIFICATION**

(45) Date of publication of patent specification: **28.06.89**　　(51) Int. Cl.⁴: **G 05 F 3/20**

(21) Application number: **86112473.3**

(22) Date of filing: **09.09.86**

(30) Priority: **19.09.85 JP 206981/85**

(43) Date of publication of application:
**25.03.87 Bulletin 87/13**

(45) Publication of the grant of the patent:
**28.06.89 Bulletin 89/26**

(84) Designated Contracting States:
**DE FR GB**

(56) References cited:
**EP-A-0 062 894**
**EP-A-0 084 177**
**EP-A-0 143 157**
**FR-A-2 420 877**
**US-A-4 307 333**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Okada, Yoshio c/o Patent Div.,**
**Toshiba K.K.**
**1-1- Shibaura 1-chome Minato-ku**
**Tokyo 105 (JP)**

(74) Representative: **Henkel, Feiler, Hänzel & Partner**
**Möhlstrasse 37**
**D-8000 München 80 (DE)**

(54) Self substrate bias generator.

Courier Press, Leamington Spa, England.

# Description

The present invention relates to an on-chip substrate bias generator and, more particularly, to an on-chip substrate bias generator for use in a large scale integrated circuit.

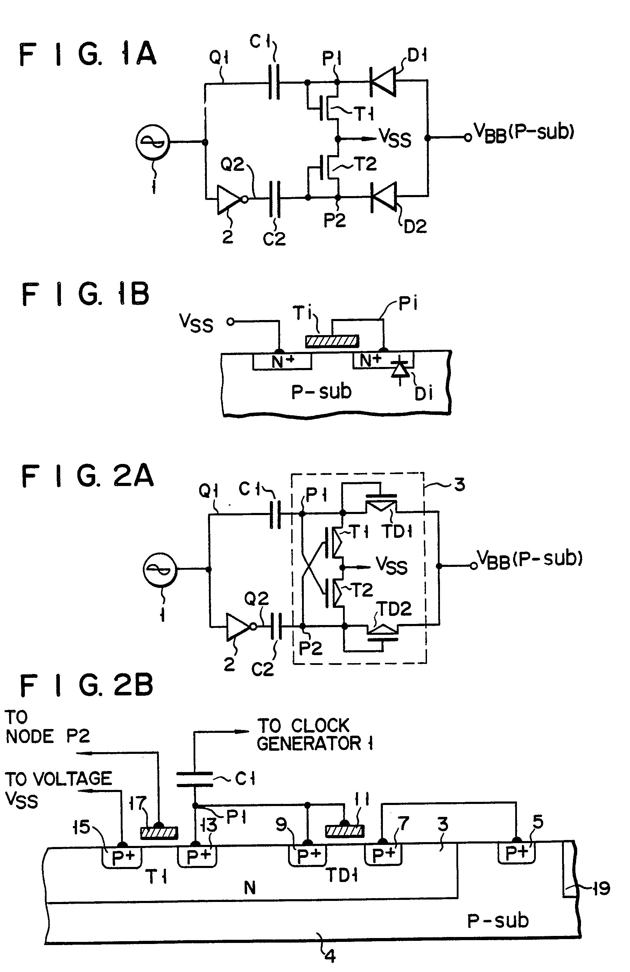

An on-chip substrate bias generator for maintaining the potential of a P-type semiconductor substrate to a predetermined potential below the earth potential (VSS) which is applied to the circuit formed on the semiconductor subtrate is known. This substrate voltage generator is formed as shown in, for example, Fig. 1A. In Fig. 1A, an output terminal of an oscillator 1 is connected through a capacitor C1 to the gate of a transistor T1, to one end of the current path of transistor T1, and to the cathode of a diode D1. The output terminal of oscillator 1 is also connected through an inverter 2 and a capacitor C2 to the gate of a transistor T2, to one end of the current path of transistor T2, and to the cathode of a diode D2. The earth potential (VSS) of the circuit formed on this substrate is supplied to the other ends of the current paths of transistors T1 and T2. The anodes of diodes D1 and D2 are connected to the semiconductor substrate. As diodes D1 and D2 in the circuit shown in Fig. 1A, the PN junctions between $N^+$ (N-type high concentration) layers serving as the drains of transistors T1 and T2 and a P-type semiconductor substrate (P-SUB) are generally used as shown in a cross sectional view of Fig. 1B.

The potential of nodes Qi (i=1 or 2) shown in Fig. 1A becomes an L level in response to a clock signal from oscillator 1 and the potential of a node Pi shown in Fig. 1A is reduced through capacitor Ci. When the potential of node Pi decreases, diode Di is turned on and the charges in the semiconductor substrate are pumped to node Pi. When the potential of node Pi becomes an H level, the charges pumped to node Pi are pumped to earth potential VSS by transistor Ti. Potential VBB of the semiconductor substrate is maintained to below earth potential VSS by the above series of operations. To efficiently use oscillator 1, two sets, each consisting of capacitors C1, C2, diodes D1, D2, and transistors T1, T2, respectively, are used. Each set operates independently.

The foregoing circuit has the following two drawbacks:

(1) The first drawback relates to transistor Ti. When transistor Ti pumps the charges which have previously been pumped to node Pi to earth potential VSS, transistor Ti operates in a pentode operation. However, the efficiency when transistor Ti pumps the changes by the pentode operation is lower than the efficiency when transistor Ti pumps the charges by the triode operation. On the other hand, the potential of node Pi decreases to the level of only VSS+VT because of the threshold voltage VT of transistor Ti. Therefore, the charges which are pumped from node Pi to potential VSS decrease by an amount of voltage VT, so that the charges which are pumped from the substrate to potential VSS are reduced.

To avoid the decrease in charges which are pumped, the method whereby the gate of transistor Ti is pulled up is also used. However, in this case, the circuit constitution becomes remarkably complicated.

(2) The second drawback relates to diode Di. When diode Di pumps the charges in the semiconductor substrate to node Pi, a number of minority carriers (electrons) are injected into the semiconductor substrate. The life time of the electrons are fairly long and when the potential of node Pi becomes an H level and the potential of the $N^+$ layer in Fig. 1B becomes high, the injected planted electrons flow back into the $N^+$ layer. Namely, the $N^+$ layer of transistor Ti connected to node Pi operates in a manner similar to the guard ring and collects the electrons. This operation intends to again attract the electrons which were injected into the substrate. The efficiency (pumping efficiency) of the substrate voltage generator for pumping the charges in the substrate to potential VSS deteriorates remarkably. According to the experiments by the applicant, it has been found that the pumping efficiency was reduced to about 1/4 as compared with the case where 'the electrons are not collected again. To maintain the constant pumping performance, it is necessary to enlarge the dimensions of the whole circuit such as capacitor Ci, transistor Ti, oscillator 1, and the like.

In addition, there is the undesirable possibility that the injected electrons may exert an adverse influence on the operation of the electronic circuit formed on the semiconductor substrate. Practically speaking, in the case where the circuit formed on the semiconductor substrate is a dynamic memory, there is a potential for destroying the stored data. For example, it is now assumed that the positive charges are accumulated in the memory cell. These positive charges attract the injected electrons and are coupled with the electrons. The accumulated positive charges gradually decrease and the stored data is destroyed in accordance with the case.

Similar disadvantages also occur when the conventional substrate voltage generator is formed on the N-type semiconductor substrate.

An object of the present invention is to provide an on-chip substrate bias generator having a high efficiency and a high reliability.

To accomplish the above object, an on-chip substrate bias generator according to the invention comprises:

a semiconductor substrate (4) of a first conductivity type;

means (1, 2) for supplying first and second signals of substantially opposite phase;

a first capacitor (C1) in which the first signal is supplied to one electrode and the other electrode is connected to a first node (P1);

a second capacitor (C2) in which the second signal is supplied to one electrode and the other electrode is connected to a second node (P2);

a well (3) of a second conductivity type formed on the semiconductor substrate (4); and

first to fourth MOS transistors (T1, T2, TD1, TD2) formed in the well (3),

wherein a current path of the first transistor (TD1) is connected between the substrate (4) and the first node (P1) and its gate is connected to the first node (P1),

a current path of the second transistor (TD2) is connected between the substrate (4) and the second node (P2) and its gate is connected to the second node (P2),

a current path of the third transistor (T1) is connected between a predetermined potential (VSS) and the first node (P1) and its gate is connected to the second node (P2), and

a current path of the fourth transistor (T2) is connected between the predetermined potential (VSS) and the second node (P2) and the gate is connected to the first node (P1).

In the above constitution, the first and second transistors (TD1, TD2) are used as what are called MOS diodes. The MOS diodes (TD1, TD2) don't inject the minority carriers into the semiconductor substrate (4) because of the first and second transistors formed in the well (3). The efficiency of pumping the charges from or to the semiconductor substrate is improved as compared with the conventional circuit. Further, the conventional circuit has a potential problem such that the electronic circuit formed on the substrate is adversely influenced by the minority carriers injected into the substrate, for example, a problem in that the data stored in the dynamic memory is destroyed. However, according to the circuit of the invention, these disadvantages are eliminated. On the other hand, the third and fourth transistors (T1, T2) operate in a triode operation and pump the charges from or to the first and second nodes to the predetermined potential. Therefore, according to the invention, the charge pumping efficiency is high. In addition, there is no need to provide a complicated circuit to remove the threshold barrier of third and fourth transistor.

This invention can be more fully understood from the following detailed description when taken in conjunction with the accompanying drawings, in which:

Figs. 1A and 1B are diagrams showing a structure of a conventional on-chip substrate bias generator;

Fig. 2A is a circuit diagram showing a constitution of an on-chip substrate bias generator according to an embodiment of the invention;

Fig. 2B is a cross sectional view for explaining a structure of a part of the on-chip substrate bias generator shown in Fig. 2A;

Figs. 3A and 3B are time charts for explaining the operation of the circuit shown in Fig. 2A;

Figs. 4A and 4B are time charts for explaining the improved operation of the circuit shown in Fig. 2A; and

Fig. 5 is a circuit diagram for supplying the signals shown in Figs. 4A and 4B.

A constitution of an on-chip substrate bias generator according to an embodiment of the present invention will now be described hereinbelow with reference to Fig. 2A. This embodiment relates to the on-chip substrate bias generator using a P-type semiconductor substrate.

The output terminal of oscillator or clock generator 1 is connected to one electrode of capacitor C1 through a node Q1. The output terminal of clock generator 1 is also connected to the input terminal of inverter 2. The output terminal of inverter 2 is connected to one electrode of capacitor C2 through node Q2. An N-type well 3 is formed on the P-type semiconductor substrate. P-channel MOS transistors T1, T2, TD1, and TD2 are formed in well 3. One end of the current path of transistor TD1 and the gate thereof are connected to the other electrode of capacitor C1. The other end of the current path of transistor TD1 is connected to the semiconductor substrate (P-SUB). The other electrode of capacitor C2 is connected to one end of the current path of transistor TD2 and to the gate of transistor TD2. The other end of the current path of transistor TD2 is connected to the semiconductor substrate. One end of the current path of transistor T1 is connected to the node P1 of the other electrode of capacitor C1 and transistor TD1. The other end of the current path of transistor T1 is connected to the terminal to which earth potential VSS is supplied. The gate of transistor T1 is connected to a node P2 of the other electrode of capacitor C2 and transistor TD2. One end of the current path of transistor T2 is connected to node P2. The other end of the current path of transistor T2 is connected to the terminal to which earth potential VSS is supplied. The gate of transistor T2 is connected to node P1.

Fig. 2B shows a practical constitution in the case where the circuit shown in Fig. 2A is formed in the semiconductor substrate. Fig. 2B shows an example of a constitution of the circuit shown in Fig. 2A on the side of transistors TD1 and T1 and capacitor C1. N-type well 3 is formed in a part of a P-type semiconductor substrate 4. P-channel MOS transistors T1 and TD1 are formed in well 3. An electrode take-out region 5 formed on semiconductor substrate 4 is connected to a $P^+$ region 7 serving as a source to transistor TD1 by wiring. A $P^+$ region 9 serving as a drain of transistor TD1 and the gate thereof are connected to a $P^+$ region 13 serving as a source of transistor T1 and the other electrode of capacitor C1 through a node P1. A $P^+$ region 15 serving as a drain of transistor T1 is connected to a terminal (not shown) to which earth potential VSS is applied. A gate 17 of transistor T1 is connected to node P2. An electronic circuit 19 (for example: dynamic memory cells) is formed in the other region of the P-type semiconductor substrate 4. The earth potential of this circuit is applied to $P^+$ region 15.

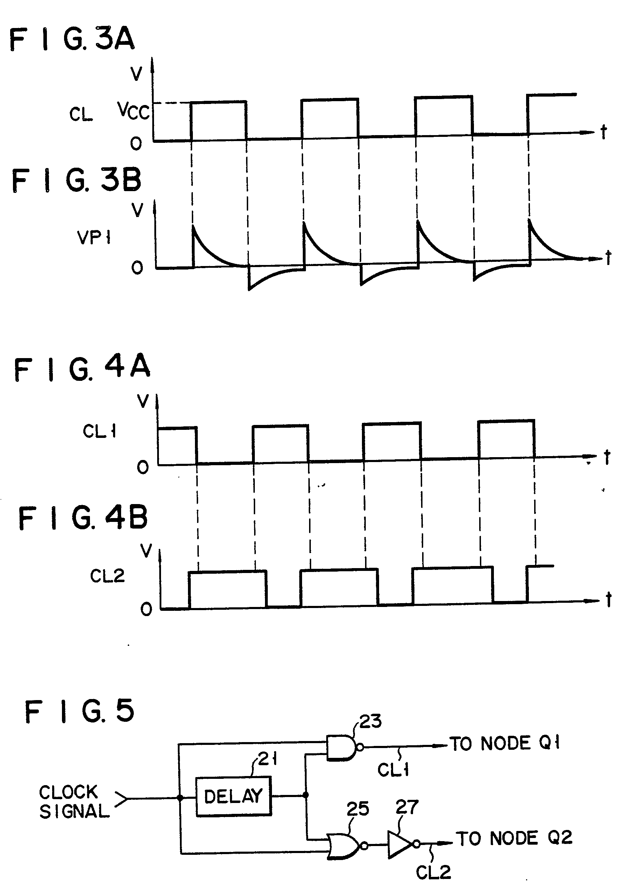

The operation of the circuit shown in Figs. 2A and 2B will now be described with reference to Figs. 3A and 3B. It is assumed that a clock signal CL as shown in Fig. 3A is output from oscillator 1. The H level of clock signal CL assumes voltage VCC and the L level assumes voltage VSS. The

3

operations of transistors T1 and TD1 and capacitor C1 will be first described for easy understanding.

When the potential of clock CL becomes the L level while potential VCC is being applied to capacitor C1, the potential of node P1 becomes VSS−VCC, so that the potential of node P1 is lower than substrate potential VBB. Transistor TD1 is turned on and the charges in the semiconductor substrate flow through node P1. When transistor TD1 is on, the potential of node P2 is at the H level and, transistor T1 is off. Therefore, the potential of node P1 gradually increases. When a potential VP1 of node P1 is higher than VBB−| VTP | (VBB is the potential of the semiconductor substrate and VTP is the threshold voltage of transistor TD1 (P-channel MOS transistor)), transistor TD1 is turned off and the inflow of the charges to node P1 is stopped. Next, when the potential of clock signal CL becomes the H level, potential VP1 of node P1 also becomes the H level and transistor TD1 is turned off. On the contrary, the potential of node P2 becomes the L level and transistor T1 is turned on. The charges accumulated in node P1 (namely, the charges pumped from the substrate to node P1 for the period of time when the potential of clock signal CL is at the L level) flow through transistor T1 to the terminal which was applied with potential VSS. The potential of node P1 gradually decreases. Since transistor T1 operates in a triode operation, potential VP1 of node P1 is reduced to earth potential VSS. Next, when the potential of clock signal CL becomes the L level, the potential of node P1 decreases to VSS−VCC. Thereafter, similar operations are repeated.

Operations similar to the above are also executed with respect to transistors T2 and TD2. The signal of the phase which is substantially opposite to that of clock signal CL is applied to node Q2 by inverter 2. Namely, when the output signal of inverter 2 becomes the L level, the potential of node P2 decreases to below earth potential VSS, because node P2 is capacitively coupled with inverter 2. The charges in the semiconductor substrate are pumped to node P2. When the output signal of inverter 2 becomes the H level, the potential of node P2 increases. At this time, the potential of node P1 is at the L level and transistor T2 is turned on, so that the charges which have been pumped to node P2 are pumped to potential VSS.

By repeating the foregoing operations, the charges in the semiconductor substrate are pumped and potential VBB of semiconductor substrate is maintained to below earth potential VSS (namely, −VCC+ | VTP | ).

Transistors TD1 and TD2 are used as so-called MOS diodes and correspond to diodes D1 and D2 in Fig. 1A. Since diodes D1 and D2 are the diodes formed on the P-type substrate, the minority carriers are injected into the substrate. Hitherto, there is the drawback such that the injected electrons flow back into nodes P1 and P2 and the pumping efficiency deteriorates. On the other hand, since MOS diodes TD1 and TD2 are the P-channel transistors formed in N-well 3, no minority carrier is injected into the substrate. Therefore, the charges don't reversely flow into the substrate and the pumping efficiency is improved according to the embodiment. The conventional circuit has a potential problem such that an adverse influence is exerted on the electronic circuit by the electrons injected into the substrate. For example, there is the problem such that the data stored in the dynamic memory is destroyed. However, according to the circuit of the embodiment, such drawbacks are completely eliminated.

In the embodiment, when the charges are pumped from node Pi (i=1 or 2) to earth potential VSS through transistor Ti, transistor Ti functions in a triode operation. This is because the base, collector, and emitter of transistor Ti are individually constituted, transistors T1 and T2 are cross-coupled, and a potential below the earth potential is applied to the gates of those transistors. Since transistor Ti operates as a triode, the efficiency to pump the charges from node P1 to potential VSS is improved as compared with that of the conventional circuit. Further, the potential of node P2 decreases to earth potential VSS because of the triode operation of transistor Ti. This point is typical when considering that the potentials of nodes P1 and P2 decrease to only VSS+VT in Fig. 1A. The charges which have been pumped to node Pi can be completely pumped to potential VSS. From this viewpoint, it will be appreciated that the substrate voltage generator according to the embodiment has an excellent pumping performance when pumping the charges in the semiconductor substrate by an amount of voltage VT as compared with the conventional circuit. In addition, there is no need to provide a complicated circuit to remove potential barrier VT.

In the embodiment, there is the potential problem such that transistors T1 and T2 are simultaneously turned on and the efficiency of the substrate voltage generator deteriorates. It is assumed that the potential of node P1 changed to the L level for explanation. After the potential of node P1 became the L level, the potential of node P2 is also maintained at the L level for the period of the delay time of inverter 2, so that transistor T1 is held to be on. At this time, the potential of node P1 is below potential VSS. Therefore, there is the risk such that the changes flow from potential VSS to node P1. In this case, the efficiency of the operation of the substrate bias generator noticeably deteriorates. To avoid such a situation, it is desirable for clock signals CL1 and CL2 to be applied to nodes Q1 and Q2 to have substantially the opposite phases as shown in Figs. 4A and 4B. Namely, the period of time when the potential (CL1) of node Q1 is at the L level ends for the period of time when the potential (CL2) of node Q2 is at the H level, the period of time when the potential of node Q2 is at the L level ends for the period of time when the potential of node Q1 is at the H level, and at the same time the phases of clock signals CL1 and CL2 are opposite. When the clock signals having substantially the opposite phases are supplied to node Q1 and Q2, transistor Ti (i=1 or 2) is turned off and thereafter, the potential of node Pi decreases to below potential VSS. Therefore, it is possible to prevent the foregoing disadvantage such that the charges reversely flow from potential VSS to nodes P1 and P2 and to improve the efficiency of the circuit.

To obtain signals as shown in Figs. 4A and 4B, it is sufficient to use the circuit of a constitution as shown in, e.g., Fig. 5. Namely, clock signal CL from oscillator 1 is input to a delay circuit 21, to one input terminal of a NAND gate 23, and to one input terminal of a NOR gate 25. The output signal of delay circuit 21 is input to the other input terminals of NAND gate 23 and of NOR gate 25. The output of NOR gate 25 is input to an inverter 27. The output terminal of inverter 27 is connected to node Q2. The output terminal of the NAND gate 23 is connected to node Q1.

In the foregoing embodiments, the clock signals having substantially opposite phases were applied to nodes P1 and P2 using one oscillator 1. The circuit to supply the clock signals is not limited to that in the embodiments. Any constitution which can supply signals of substantially opposite phases (including the case where the phases are completely opposite) may be also used.

An example whereby the P-type semiconductor substrate was used has been described in the embodiments. This invention is not limited to this example. The invention may also use the N-type semiconductor substrate. In this case, the on-chip substrate bias generator pumps the charges from the power source voltage (VCC) into the semiconductor substrate, thereby maintaining the potential of the semiconductor substrate to a potential above the power source potential. In this case, a P-type well region is formed on the N-type semiconductor substrate. N-channel transistors are formed in this well region. Power source voltage (VCC) is applied to one end of each current path of transistors T1 and T2. The other circuit constitution and the like are the same as those of the circuit shown in Fig. 2A. In this case, in handling signals CL1 and CL2 shown in Figs. 4A and 4B, it is sufficient to reverse the logic levels of these signals. Such reversed signals may be obtained and used by inverting the output signals of the circuit shown in Fig. 5.

## Claims

1. An on-chip substrate bias generator for implanting charges into a semiconductor substrate or pumping the charges from the semiconductor substrate and for maintaining the potential of said substrate at a desired constant level, characterized in that:
said on-chip substrate bias generator comprises:
a semiconductor substrate (4) of a first conductivity type;
means (1, 2) for supplying first and second signals of substantially opposite phase;
a first capacitor (C1) in which said first signal is supplied to one electrode and the other electrode is connected to a first node (P1);
a second capacitor (C2) in which said second signal is supplied to one electrode and the other electrode is connected to a second node (P2);
a well (3) of a second conductivity type formed in said semiconductor substrate (4); and
first to fourth MOS transistors (TD1, TD2, T1, T2) formed in said well (3),
a current path of said first MOS transistor (TD1) being connected between the substrate (4) and said first node (P1) and its gate being connected to the first node (P1),
a current path of said second MOS transistor (TD2) being connected between the substrate (4) and said second node (P2) and its gate being connected to the second node (P2),
a current path of said third MOS transistor (T1) being connected between a predetermined potential (VSS) and said first node (P1) and its gate being connected to the second node (P2), and
a current path of said fourth MOS transistor (T2) being connected between said predetermined potential (VSS) and said second node (P2) and its gate being connected to the first node (P1).

2. A substrate bias generator according to claim 1, characterized in that said semiconductor substrate (4) is a P-type semiconductor substrate, and said substrate bias generator is a circuit for pumping the charges in the semiconductor substrate (4) to said predetermined potential and maintaining the potential of the semiconductor substrate (4) to a potential below said predetermined potential.

3. A substrate bias generator according to claim 2, wherein in use, said predetermined potential is substantially the same as the earth potential to be applied to an electronic circuit formed on the same substrate as the substrate bias generator.

4. A substrate bias generator according to claim 1, characterized in that said means (1, 21 to 27) for supplying said first and second signals is means for supplying clock signals such as to set a potential of the first node (P1) to an L level after the third transistor (T1) is turned off and to set a potential of the second node (P2) to an L level after the fourth transistor (T2) is turned off.

5. A substrate bias generator according to claim 4, characterized in that said means (1, 21 to 27) for supplying said first and second signals is means for supplying clock signals such that the period of time when said second clock signal is at an L level ends for the period of time when said first clock signal is at an H level, and the period of time when the first clock signal is at an L level ends for the period of time when the second clock signal is at an H level.

6. A substrate bias generator according to claim 5, characterized in that the means for supplying said first and second signals comprises:
means (1) for supplying a third clock signal;
delay means (21) for delaying said third clock signal;

means (23) for receiving said third clock signal and a delay signal from said delay means, for getting NAND of said third clock signal and said delay signal, and for outputting this NAND as said first signal; and

means (25, 27) for receiving said first signal and said delay signal, getting OR of the third signal and the delay signal, and for outputting this OR as said second signal.

7. A substrate bias generator according to claim 1, characterized in that said semiconductor substrate is an N-type semiconductor substrate, and said substrate bias generator is a circuit for pumping the charges from said predetermined potential into said semiconductor substrate and for maintaining the potential of the semiconductor substrate to a potential above said predetermined potential.

8. A substrate bias generator according to claim 7, wherein, in use, said predetermined potential is substantially the same as the power source potential to be applied to an electronic circuit; formed on the same substrate as the substrate bias generator.

9. A substrate bias generator according to claim 7, characterized in that the means (1, 21 to 27) for supplying said first and second signals is means for supplying clock signals so as to set a potential of said first node (P1) to an H level after said third transistor (T1) is turned off and to set a potential of said second node (P2) to an H level after said fourth transistor (T2) is turned off.

10. A substrate bias generator according to claim 9, characterized in that the means for supplying said first and second clock signals comprises:

means (1) for supplying a third clock signal;

delay means (21) for delaying said third clock signal;

means (23) for receiving said third clock signal and a delay signal from said delay means, for getting AND of said third clock signal and said delay signal, and for outputting this AND as said first signal; and

means (25, 27) for receiving said first signal and said delay signal, for getting NOR of the third signal and the delay signal, and for outputting this NOR as said second signal.

**Patentansprüche**

1. Auf-chip-Substratvorspannungsgenerator zum Implantieren von Ladungen in ein Halbleitersubstrat oder zum Pumpen der Ladungen aus dem Halbleitersubstrat und zum Aufrechterhalten des Potentials des Substrats bei einem gewünschten konstanten Pegel, dadurch gekennzeichnet, daß

der Auf-chip-Substratvorspannungsgenerator aufweist:

ein Halbleitersubstrat (4) eines ersten Leitfähigkeitstyps;

eine Einrichtung (1, 2) zum Einspeisen erster und zweiter Signale mit im wesentlichen entgegengesetzter Phase,

einen ersten Kondensator (C1), bei dem das erste Signal zu einer Elektrode gespeist wird und bei dem die andere Elektrode mit einem ersten Knoten (P1) verbunden ist;

einen zweiten Kondensator (C2), bei dem das zweite Signal zu einer Elektrode gespeist ist und bei dem die andere Elektrode mit einem zweiten Knoten (P1) verbunden ist;

eine Wanne (3) eines zweiten Leitfähigkeitstyps, die im Halbleitersubstrat (4) ausgeführt ist; und

erste bis vierte MOS-Transistoren (TD1, TD2, T1, T2), die in der Wanne (3) ausgebildet sind,

wobei ein Strompfad des ersten MOS-Transistors (TD1) zwischen dem Substrat und dem ersten Knoten (P1) verbunden ist und Gate des ersten MOS-Transistors an den ersten Knoten (P1) angeschlossen ist,

wobei ein Strompfad des zweiten MOS-Transistors (TD2) zwischen dem Substrat (4) und dem zweiten Knoten (P2) verbunden ist und Gate des zweiten MOS-Transistors (TD2) an den zweiten Knoten (P2) angeschlossen ist,

wobei ein Strompfad des dritten MOS-Transistors (T1) zwischen einem vorbestimten Potential (VSS) und dem ersten Knoten (P1) verbunden ist und Gate des dritten MOS-Transistors (T1) an den zweiten Knoten (P2) angeschlossen ist, und

wobei ein Strompfad des vierten MOS-Transistors (T2) zwischen dem vorbestimmten Potential (VSS) und dem zweiten Knoten (P2) verbunden ist und Gate des vierten MOS-Transistors (T2) an den ersten Knoten (P1) angeschlossen ist.

2. Substratvorspannungsgenerator nach Anspruch 1, dadurch gekennzeichnet, daß das Halbleitersubstrat ein P-Typ-Halbleitersubstrat ist und daß der Substratvorspannungsgenerator eine Schaltung zum Pumpen der Ladungen im Halbleitersubstrat (4) auf das vorbestimmte Potential und zum Halten des Potentials des Halbleitersubstrates (4) auf einem Potential unter dem vorbestimmten Potential ist.

3. Substratvorspannungsgenerator nach Anspruch 2, bei dem, im Gebrauch, das vorbestimmte Potential im wesentlichen das gleiche wie das Erdpotential ist, das an eine elektronische Schaltung zu legen ist, die in dem gleichen Substrat wie der Substratvorspannungsgenerator ausgebildet ist.

4. Substratvorspannungsgenerator nach Anspruch 1, dadurch gekennzeichnet, daß die Einrichtung (1, 21, bis 27) zum Einspeisen der ersten und zweiten Signale eine Einrichtung zum Einspeisen von Taktsignalen derart ist, um ein Potential des ersten Knotens (P1) auf einen L-Pegel nach dem Ausschalten des dritten Transistors (T1) zu setzen und um ein Potential des zweiten Knotens (P2) auf einen L-Pegel nach dem Ausschalten des vierten Transistors (T2) zu setzen.

5. Substratvorspannungsgenerator nach Anspruch 4, dadurch gekennzeichnet, daß die Einrichtung (1, 21 bis 27) zum Einspeisen der ersten und zweiten Signale eine Einrichtung zum Einspeisen von Taktsignalen der Art ist, daß die Zeitdauer, in der das zweite Taktsignal auf einem L-Pegel ist, für die Zeitdauer endet, in der das erste Taktsignal auf einem H-Pegel ist, und daß die Zeitdauer, in der das erste Taktsignal auf einem L-Pegel ist, für die Zeitdauer endet, in der das zweite Taktsignal auf einem H-Pegel ist.

6. Substratvorspannungsgenerator nach Anspruch 5, dadurch gekennzeichnet, daß die Einrichtung zum Einspeisen der ersten und zweiten Signale aufweist:

eine Einrichtung (1) zum Einspeisen eines dritten Taktsignales;

eine Verzögerungseinrichtung (21) zum Verzögern des dritten Taktsignales;

eine Einrichtung (23) zum Empfangen des dritten Taktsignales und eines Verzögerungssignales von der Verzögerungseinrichtung, zum Erhalten einer NAND-Verknüpfung aus dem dritten Taktsignal und dem Verzögerungssignal und zum Abgeben dieser NAND-Verknüpfung als das erste Signal; und

eine Einrichtung (25, 27) zum Empfangen des ersten Signales und des Verzögerungssignales, zum Erhalten einer ODER-Verknüpfung aus dem dritten Signal und dem Verzögerungssignal und zum Abgeben dieser ODER-Verknüpfnung als das zweite Signal.

7. Substratvorspannungsgenerator nach Anspruch 1, dadurch gekennzeichnet, daß das Halbleitersubstrat ein N-Typ-Halbleitersubstrat ist, und daß der Substratvorspannungsgenerator eine Schaltung zum Pumpen der Ladungen von dem vorbestimmten Potential in das Halbleitersubstrat und zum Halten des Potentials des Halbleitersubstrats auf einem Potential über dem vorbestimmten Potential ist.

8. Substratvorspannungsgenerator nach Anspruch 7, bei dem, im Gebrauch, das vorbestimmte Potential im wesentlichen das gleiche wie das Strom- bzw. Spannungsquellenpotential ist, das an eine elektronische Schaltung zu legen ist, die in dem gleichen Substrat wie der Substratvorspannungsgenerator ausgebildet ist.

9. Substratvorspannungsgenerator nach Anspruch 7, dadurch gekennzeichnet, daß die Einrichtung (1, 21 bis 27) zum Einspeisen der ersten und zweiten Signale eine Einrichtung zum Einspeisen von Taktsignalen ist, um ein Potential des ersten Knotens (P1) auf einen H-Pegel nach Ausschalten des dritten Transistors (T1) zu setzen und um ein Potential des zweiten Knotens (P2) auf einen H-Pegel nach Ausschalten des vierten Transistors (T2) zu setzen.

10. Substratvorspannungsgenerator nach Anspruch 9, dadurch gekennzeichnet, daß die Einrichtung zum Einspeisen der ersten und zweiten Taktsignale aufweist:

eine Einrichtung (1) zum Einspeisen eines dritten Taktsignales;

eine Verzögerungseinrichtung (21) zum Verzögern des dritten Taktsignales;

eine Einrichtung (23) zum Empfangen des dritten Taktsignales und eines Verzögerungssignales von der Verzögerungseinrichtung zum Erhalten einer UND-Verknüpfung des dritten Taktsignales und des Verzögerungssignales und zum Abgeben dieser UND-Verknüpfung als das erste Signal; und

eine Einrichtung (25, 27) zum Empfangen des ersten Signales und des Verzögerungssignales, zum Erhalten einer NOR-Verknüpfung des dritten Signalen und des Verzögerungssignales und zum Abgeben dieser NOR-Verknüpfung als das zweite Signal.

**Revendications**

1. Générateur de polarisation de substrat sur pastille pour implanter des charges dans un substrat semiconducteur ou pomper les charges du substrat semiconducteur et pour maintenir le potentiel du substrat à un niveau constant voulù, caractérisé en ce que le générateur de polarisation de substrat sur pastille comprend:

un substrat semiconducteur (4) d'un premier type de conductivité;

un moyen (1, 2) pour fournir des premier et deuxième signaux de phase effectivement opposée;

un premier condensateur (C1) dans lequel le premier signal est fourni à une électrode et l'autre électrode est connectée à un premier noeud (P1);

un deuxième condensateur (C2) dans lequel le deuxième signal est fourni à une électrode et l'autre électrode est connectée à un deuxième noeud (P2);

un puits (3) d'un deuxième type de conductivité formé dans le substrat semiconducteur (4); et

des premier à quatrième transistors MOS (TD1, TD2, T1, T2) formés dans le puits (3),

un chemin de courant du premier transistor MOS (TD1) étant connecté entre le substrat (4) et le premier noeud (P1) et sa grille étant connectée au premier noeud (P1),

un chemin de courant du deuxième transistor MOS (TD2) étant connecté entre le substrat (4) et le deuxième noeud (P2) et sa grille étant connectée au deuxième noeud (P2),

un chemin de courant du troisième transistor MOS (T1) étant connecté entre une borne de potentiel prédéterminé (VSS) et le premier noeud (P1) et sa grille étant connectée au deuxième noeud (P2), et

un chemin de courant du quatrième transistor MOS (T2) étant connecté entre la borne de potentiel prédéterminé (VSS) et le deuxième noeud (P2) et sa grille étant connectée au premier noeud (P1).

2. Générateur de polarisation de substrat selon la revendication 1, caractérisé en ce que le substrat semiconducteur (4) est un substrat semiconducteur de type P, et le générateur de polarisation de substrat est un circuit pour pomper les charges dans le substrat semiconducteur (4) à un potentiel prédéterminé et pour maintenir le potentiel du substrat semiconducteur (4) à un potentiel inférieur au potentiel prédéterminé.

3. Générateur de polarisation de substrat selon la revendication 2, dans lequel, en cours d'utilisation, le potentiel prédéterminé est effectivement le même que le potentiel de terre à appliquer à un circuit électronique formé sur le même substrat que le générateur de polarisation de substrat.

4. Générateur de polarisation de substrat selon la revendication 1, caractérisé en ce que le moyen (1, 21 à 27) pour fournir les premier et deuxième signaux est un moyen pour fournir des signaux d'horloge tels que pour régler un potentiel du premier noeud (P1) à un niveau B après que le troisième transistor (T1) ait été bloqué et pour régler le potentiel du deuxième noeud (P2) à un niveau B après que le quatrième transistor (T2) ait été bloqué.

5. Générateur de polarisation de substrat selon la revendication 4, caractérisé en ce que le moyen (1, 21 à 27) pour fournir les premier et deuxième signaux est un moyen pour fournir des signaux d'horloge tels que le période de temps où le deuxième signal d'horloge est à un niveau B se termine pendant la période de temps où le premier signal d'horloge est à un niveau H, et la période de temps où le premier signal d'horloge est à un niveau B se termine pendant la période de temps où le deuxième signal d'horloge est à un niveau H.

6. Générateur de polarisation de substrat selon la revendication 5, caractérisé en ce que le moyen pour fournir les premier et deuxième signaux comprend:

un moyen (1) pour fournir un troisième signal d'horloge;

un moyen à retard (21) pour retarder le troisième signal d'horloge;

un moyen (23) pour recevoir le troisième signal d'horloge et un signal à retard du moyen à retard, pour obtenir la combinaison logique NON-ET du troisième signal d'horloge et du signal à retard, et pour sortir ce signal résultant de la combinaison NON-ET comme premier signal; et

un moyen (25, 27) pour recevoir le premier signal et le signal à retard, obtenir la combinaison logique OU du troisième signal et du signal à retard, et pour sortir ce signal résultant de la combinaison OU comme deuxième signal.

7. Générateur de polarisation de substrat selon la revendication 1, caractérisé en ce que le substrat semiconducteur est un substrat semiconducteur de type N, et le générateur de polarisation de substrat est un circuit pour pomper les charges de la borne de potentiel prédéterminé dans le substrat semiconducteur et pour maintenir le potentiel du substrat semiconducteur à un potentiel supérieur au potentiel prédéterminé.

8. Générateur de polarisation de substrat selon la revendication 7, dans lequel, en cours d'utilisation, le potentiel prédéterminé est le même que le potentiel de source de tension d'alimentation à appliquer à un circuit électronique formé sur le même substrat que le générateur de polarisation de substrat.

9. Générateur de polarisation de substrat selon la revendication 7, caractérisé en ce que le moyen (1, 21 à 27) pour fournir les premier et deuxième signaux est un moyen pour fournir des signaux d'horloge de manière à régler le potentiel du premier noeud (P1) à un niveau H après que le troisième transistor (T1) ait été bloqué et pour régler le potentiel du deuxième noeud (P2) à un niveau H après que le quatrième transistor (T2) ait été bloqué.

10. Générateur de polarisation de substrat selon la revendication 9, caractérisé en ce que le moyen pour fournir les premier et deuxième signaux d'horloge comprend:

un moyen (1) pour fournir un troisième signal d'horloge;

un moyen à retard (21) pour retarder le troisième signal d'horloge;

un moyen (23) pour recevoir le troisième signal d'horloge et un signal à retard du moyen à retard, pour obtenir la combinaison logique ET du troisième signal d'horloge et du signal à retard, et pour sortir le signal résultant de la combinaison ET comme premier signal; et

un moyen (25, 27) pour recevoir le premier signal et le signal à retard, pour obtenir la combinaison logique NI du troisième signal et du signal à retard, et pour sortir ce signal résultant de la combinaison NI comme deuxième signal.

FIG. 1A

FIG. 1B

FIG. 2A

FIG. 2B

# F I G. 3A

# F I G. 3B

# F I G. 4A

# F I G. 4B

# F I G. 5